Europäisches Patentamt

European Patent Office

Office européen des brevets

(19)

(11) Numéro de publication: **0 240 645**
**A1**

(12) **DEMANDE DE BREVET EUROPEEN**

(21) Numéro de dépôt: **86402862.6**

(22) Date de dépôt: **19.12.86**

(51) Int. Cl.4: **H03H 3/04**

(30) Priorité: **24.12.85 FR 8519122**

(43) Date de publication de la demande:
**14.10.87 Bulletin 87/42**

(84) Etats contractants désignés:
**BE DE FR GB**

(71) Demandeur: **COMPAGNIE D'ELECTRONIQUE ET DE PIEZO-ELECTRICITE - C.E.P.E.**
**44, rue de la Glacière**
**F-95100 Argenteuil(FR)**

(72) Inventeur: **Tung, Pham Ngu**
**THOMSON-CSF SCPI 19, avenue de Messine**
**F-75008 Paris(FR)**

(74) Mandataire: **Ruellan-Lemonnier, Brigitte et al**
**THOMSON-CSF SCPI 19, avenue de Messine**
**F-75008 Paris(FR)**

(54) **Procédé et banc de mise à la fréquence d'un résonateur monolithique couplé.**

(57) La présente invention concerne un procédé de mise à la fréquence d'un quartz monolithique couplé.

Ce procédé consiste à réaliser en une seule fois, une métallisation de base, puis la détection de la courbe de transmission en fréquence du quartz monté en court-circuit ; en utilisant cette courbe, on mesure à un instant donné les fréquences haute et basse du quartz ($F_H$, $F_B$) et on vérifie l'équilibrage ; les fréquences haute et basse sont comparées aux fréquences à obtenir et le résultat de la comparaison est envoyé comme commande des caches de métallisation, les opérations de mesure et de comparaison des fréquences étant recommencées jusqu'à l'obtention des valeurs désirées avec, à chaque fois, vérification de l'équilibrage.

Fig.4

EP 0 240 645 A1

## PROCEDE ET BANC DE MISE A LA FREQUENCE D'UN RESONATEUR MONOLITHIQUE COUPLE.

La présente invention concerne un procédé et un banc de mise à la fréquence d'un résonateur monolithique couplé, notamment d'un quartz.

Un quartz monolithique couplé est constitué essentiellement d'une lame de quartz revêtue sur une face de deux électrodes séparées et sur l'autre face, soit d'une électrode commune, soit de deux électrodes séparées reliées entre elles. Ce type de quartz est utilisé notamment dans les filtres adaptés aux circuits de filtrage des moyennes fréquences des récepteurs radio.

Actuellement, l'ajustage à la fréquence d'un quartz monolithique couplé est réalisé après métallisation des électrodes sur la lame de quartz et fixation du quartz sur son support.

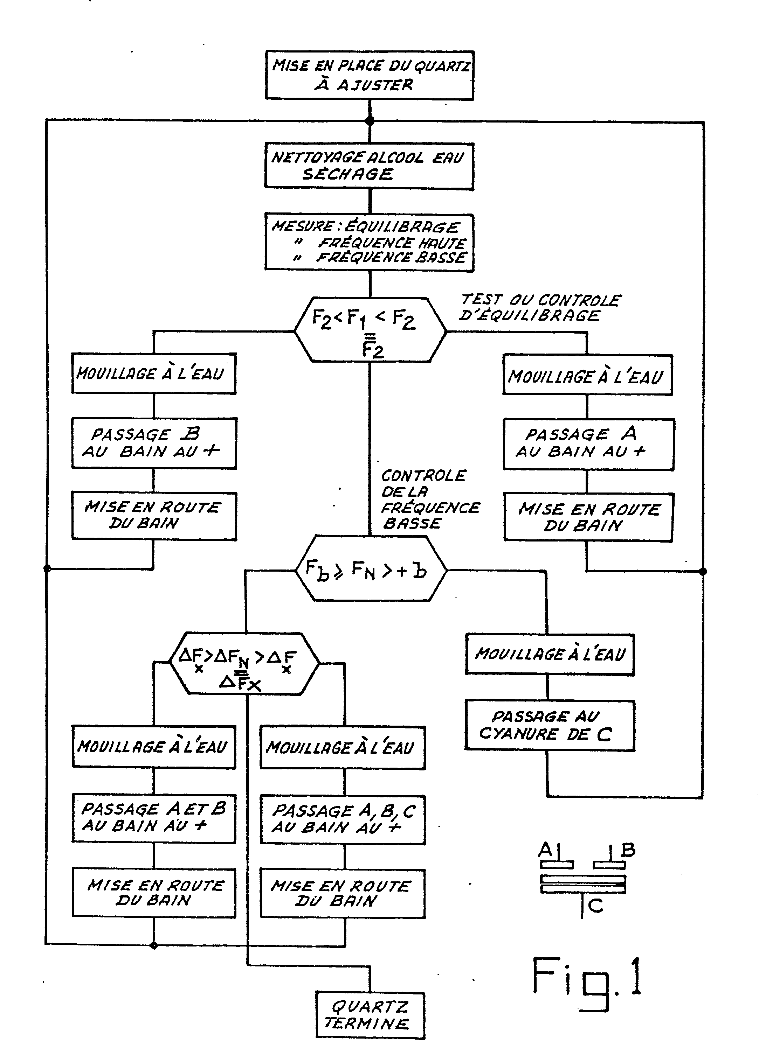

Différentes méthodes peuvent être utilisées pour réaliser cet ajustage. Parmi ces méthodes, on peut mentionner le dépôt électrolytique de sel d'or sur les métallisations du quartz. Cette méthode - schématisée sur l'organigramme de la figure 1 consiste tout d'abord à mesurer, par exemple par contrôle de phase, les différentes fréquences du quartz, à savoir la fréquence haute, la fréquence basse et l'équilibrage. On contrôle alors l'équilibrage. Pour ce faire, suivant les valeurs obtenues, soit l'on passe l'une ou l'autre des électrodes séparées au bain électrolytique, puis l'on recommence les opérations de mesure, soit, l'équilibrage étant obtenu, on réalise le contrôle de la fréquence basse. Dans ce cas, si la fréquence basse est inférieure à la fréquence nominale, on passe l'électrode commune ou les deux électrodes couplées dans un bain de cyanure puis l'on recommence les opérations de mesure. Si la fréquence basse est supérieure ou égale à la fréquence nominale, l'on effectue le contrôle de la bande passante donnée par la différence entre la fréquence haute et la fréquence basse. Si la bande passante est supérieure à la bande passante désirée, l'on passe les deux électrodes séparées au bain électrolytique ; si elle est inférieure, toutes les électrodes sont passées au bain électrolytique. L'opération d'ajustage est terminée lorsque la bande passante est égale à la bande passante désirée.

Les principaux inconvénients de cette méthode entièrement manuelle résident dans le fait d'être très longue et de faire appel principalement à l'expérience de l'opératrice. Dans ce cas, en effet la moyenne de fabrication est de vingt-cinq quartz par jour pour une durée de travail de sept heures.

Pour remédier à ces inconvénients, la société américaine Transat Corporation a mis au point un procédé et un dispositif d'ajustage à la fréquence d'un quartz monolithique couplé qui consistent à réaliser des dépôts supplémentaires sur certaines parties des électrodes. Ainsi, la bande passante est ajustée en métallisant une petite partie située entre les deux électrodes du côté commun ou en métallisant le centre des deux électrodes du côté opposé et la fréquence nominale est ajustée en métallisant le centre des électrodes du côté commun. Cette méthode, bien que rapide, nécessite un tri préalable des quartz après usinage, car l'ajustage en fréquence des quartz monolithiques couplés est limité, dans ce système, à 0,15 % de la fréquence nominale et à 30 % de la bande passante. Il est donc nécessaire d'effectuer un ajustage plus précis, par attaque chimique, avant métallisation. D'autre part, les deux procédés d'ajustage décrits ci-dessus sont réalisés séparément de la métallisation de base. De ce fait, l'ajustage en fréquence est susceptible de modifier d'autres caractéristiques du quartz.

La présente invention a pour but de remédier à ces inconvénients par un procédé et un dispositif de mise à la fréquence d'un résonateur monolithique couplé qui consiste à réaliser par évaporation sous vide une métallisation totale asservie permettant d'ajuster la fréquence nominale et la bande passante du quartz.

En conséquence, la présente invention a pour objet un procédé de mise à la fréquence d'un quartz monolithique couplé comportant sur deux faces en vis-à-vis deux électrodes séparées et une électrode commune on deux électrodes couplées, caractérisé en ce que l'on réalise, en une seule fois, une métallisation de base, puis la détection de la courbe de transmission en fréquence du quartz monté en court-circuit ; en utilisant cette courbe, on mesure à un instant donné les fréquences haute et basse du quartz et on vérifie l'équilibrage ; les fréquences haute et basse sont comparées aux fréquences à obtenir et le résultat de la comparaison est envoyé comme commande des caches de métallisation, les opérations de mesure et de comparaison des fréquences étant recommencées jusqu'à l'obtention des valeurs désirées avec, à chaque fois, vérification de l'équilibrage.

Selon un mode de réalisation préférentiel de la présente invention, le procédé consiste :

a) à réaliser une métallisation de base,

b) pendant toute la durée des opérations suivantes, à détecter cycliquement pour chaque électrode séparée la courbe de transmission en fréquence du quartz monté en court-circuit,

c) à réaliser l'équilibrage du quartz en métallisant l'une ou l'autre des deux électrodes séparées pour amener en concordance les zones de transmission de deux courbes successives correspondant aux électrodes en court-circuit,

d) à l'aide des courbes ci-dessus, à déterminer les fréquences haute et basse du quartz à un instant donné,

e) à calculer la bande passante,

f) à comparer la bande passante à une bande passante de référence,

g) à métalliser les deux électrodes séparées pour amener la bande passante calculée à la valeur de la bande passante de référence,

h) à, simultanément, comparer la fréquence basse à une fréquence nominale de référence,

i) à métalliser l'électrode commune ou les deux électrodes couplées pour amener la fréquence basse détectée à la valeur de la fréquence nominale de référence,

j) à équilibrer le quartz comme décrit en c),

k) puis, à reprendre les opérations en d) jusqu'à ce que les valeurs désirées de la bande passante et de la fréquence basse soient obtenues et que l'équilibrage soit réalisé et, à ce moment, arrêter la métallisation.

Selon une autre caractéristique de la présente invention, pour éviter tout dépassement des valeurs de référence, ce qui nécessite ensuite de démétalliser le quartz et de recommencer l'opération de mise à la fréquence, l'on compare aussi la fréquence basse à une fréquence de seuil et lorsque cette fréquence de seuil est atteinte, l'on réduit la vitesse de métallisation. Plusiers fréquences de seuil peuvent être déterminées.

Selon un mode de réalisation particulier de la présente invention, les métallisations des deux électrodes séparées, de l'électrode commune ou des électrodes couplées et de l'une ou l'autre des deux électrodes séparées sont réalisées en agissant sur trois caches mobiles. En fait, les caches utilisés pour la métallisation de l'électrode commune et pour la métallisation des deux électrodes séparées sont commandées automatiquement en fonction du résultat des différentes comparaisons tandis que le cache pour la métallisation de l'une ou l'autre des électrodes séparées est commandé manuellement.

La présente invention concerne aussi un banc pour la mise en oeuvre du procédé ci-dessus. Ce banc comporte essentiellement une cloche de métallisation munie de moyens de métallisation et de caches mobiles, un dispositif pour mesurer à chaque instant la courbe de transmission en fréquence du quartz monté en court-circuit, un dispositif pour commuter cycliquement l'électrode séparée montée en court-circuit, des moyens pour réaliser à partir des courbes de transmission l'équilibrage du quartz, des moyens pour réaliser, à chaque instant, à partir des courbes de transmission, la détection et le suivi des fréquences haute, basse et nominale du quartz, des moyens permettant d'utiliser les différentes fréquences pour commander les moyens de métallisation et, au moins, certains des caches mobiles.

La présente invention sera mieux comprise à la lecture de la description d'un banc de mise à la fréquence d'un résonateur monolithique couplé conforme à la présente invention, cette description étant faite ci-après avec référence aux dessins ci-annexés dans lesquels:

-la figure 1 est un organigramme d'un procédé d'ajustage à la fréquence de l'art antérieur,

-les figures 2A et 2B sont respectivement un schéma d'un quartz monté en court-circuit pour la mesure de la courbe de transmission en fréquence et la représentation de cette courbe de transmission en fréquence,

-la figure 3 représente différentes courbes et schémas expliquant le principe utilisé dans le procédé de la présente invention,

-la figure 4 est une vue synoptique d'un banc de mise à la fréquence utilisé dans la présente invention,

-la figure 5 est un schéma synoptique du circuit de wobulation et de contrôle des fréquences du quartz utilisé dans le banc de la figure 4,

-la figure 6 est un schéma synoptique du circuit logique de contrôle de figure 5,

-les figures 7A, 7B et 7C sont respectivement un schéma d'un détecteur de crête utilisé dans le circuit de la figure 6 et les courbes des tensions en entrée et en sortie dudit circuit,

-les figures 8A, 8B, 8C et 8D sont respectivement un schéma du circuit d'asservissement utilisé dans le circuit de la figure 6 et les tensions en différents points de ce circuit,

-les figures 9A à 9I représentent les signaux obtenus en différents points du circuit de la figure 6,

-les figures 10A à 10E représentent la position des caches en différents moments du procédé.

Le principe mis en oeuvre dans le procédé de la présente invention consiste à détecter la courbe de transmission en fréquence d'un résonateur monolithique couplé monté en court-circuit et à utiliser les fréquences données par cette courbe pour commander la métallisation des électrodes du résonateur.

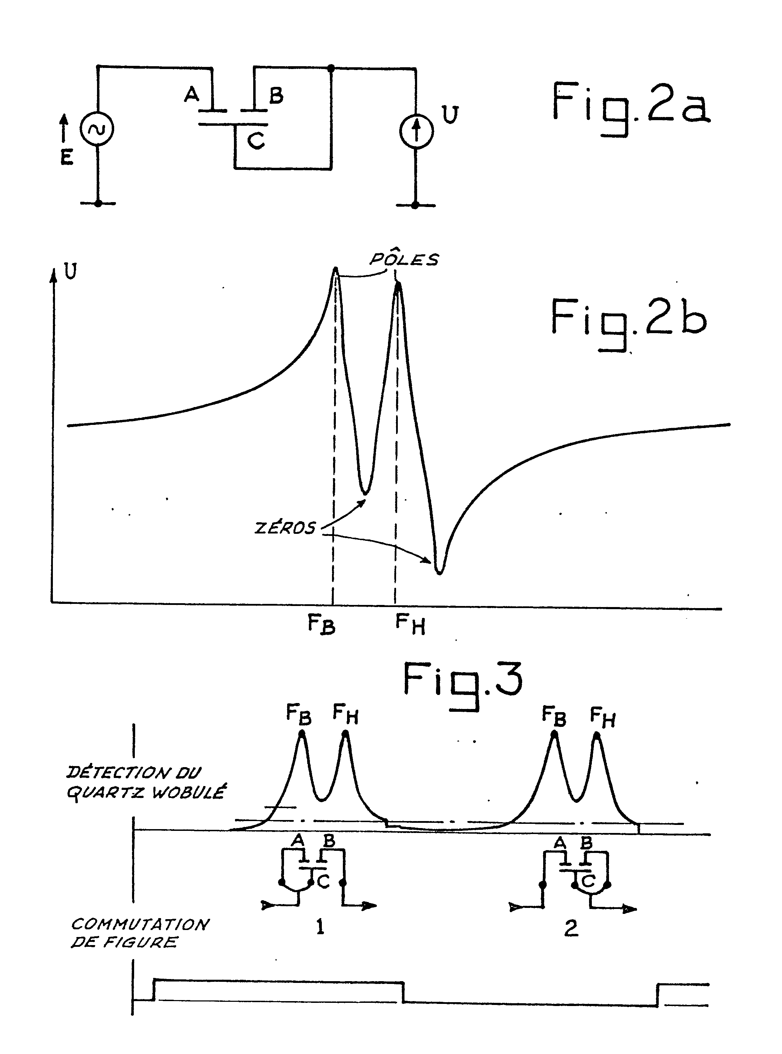

Ainsi, lorsque le quartz, symbolisé par les électrodes séparées A et B et l'électrode commune C, est monté de telle sorte qu'une des électrodes séparées, à savoir l'électrode B, soit couplée avec l'électrode commune C, si l'on applique une tension E de fréquence variable à l'entrée du quartz, on obtient en sortie une tension U qui varie comme représenté sur la courbe de la figure 2B. Sur cette courbe, on observe deux pôles de transmission en fréquence et deux zéros. Or, les pôles se trouvent au niveau des fréquences basse et haute du quartz. Il est donc possible en détectant les deux maxima de la courbe de transmission en fréquence d'obtenir la fréquence basse et la fréquence haute du quartz.

D'autre part, comme représenté sur la figure 3, si l'on commute cycliquement l'électrode séparée A ou B mise en court-circuit avec l'électrode C, on obtient deux courbes de transmission en fréquence. Or, l'équilibrage du quartz est réalisé lorsque ces deux courbes se superposent. Dans la présente invention, on réalise donc l'équilibrage du quartz en amenant les deux courbes représentées sur la figure 3 à se superposer, comme cela sera expliqué de manière plus détaillée ci-après.

Ainsi, conformément au procédé de la présente invention, on réalise tout d'abord une métallisation de base sur la lame de quartz qui permet à cette lame d'entrer en vibration et en conséquence de détecter la courbe de transmission en fréquence. Puis, pendant toute la durée des opérations suivantes, on détecte cycliquement, pour chaque électrode séparée mise en court-circuit, la courbe de transmission en fréquence du quartz. Les deux courbes ainsi obtenues sont utilisées pour réaliser l'équilibrage du quartz. Ainsi, on métallise l'une ou l'autre des deux électrodes séparées de manière à amener. en concordance les zéros de transmission de deux courbes successives. Puis, à l'aide des deux courbes ci-dessus, on détermine les fréquences haute et basse du quartz à un instant donné. En utilisant les fréquences ainsi déterminées, on calcule la bande passante et on compare cette bande passante à une bande passante de référence qui correspond en fait à la bande passante à obtenir pour le quartz que l'on métallise. En fonction du résultat de la comparaison, on métallise les deux électrodes séparées de manière à amener la bande passante calculée à la valeur de la bande passante de référence. Simultanément, on compare la fréquence basse déterminée à partir de la courbe de transmission en fréquence à une fréquence nominale de référence et on métallise l'électrode commune ou les deux électrodes couplées pour amener la fréquence base détectée à la valeur de la fréquence nominale de référence, à savoir la fréquence nominale choisie pour le quartz. On vérifie alors à nouveau l'équilibrage du quartz de la manière décrite ci-dessus et on recommence les opérations de mesure des fréquences haute et basse du quartz à un instant donné jusqu'à ce que les valeurs désirées de la bande passante et de la fréquence basse soient obtenues et que l'équilibrage soit réalisé, puis on arrête la métallisation.

Le procédé ci-dessus a été mis au point en utilisant la bande passante et la fréquence basse du quartz. Toutefois, il est évident pour l'homme de l'art que l'on peut utiliser simplement la fréquence basse et la fréquence haute du quartz pour commander la métallisation ou choisir d'autres paramètres pouvant être obtenus à partir de la courbe de transmission en fréquence. D'autre part, pour éviter tout dépassement des valeurs de référence, conformément au procédé de la présente invention, on compare la fréquence basse à une fréquence de seuil et lorsque cette fréquence de seuil est atteinte, l'on réduit la vitesse de métallisation de manière à arrêter la métallisation au bon moment.

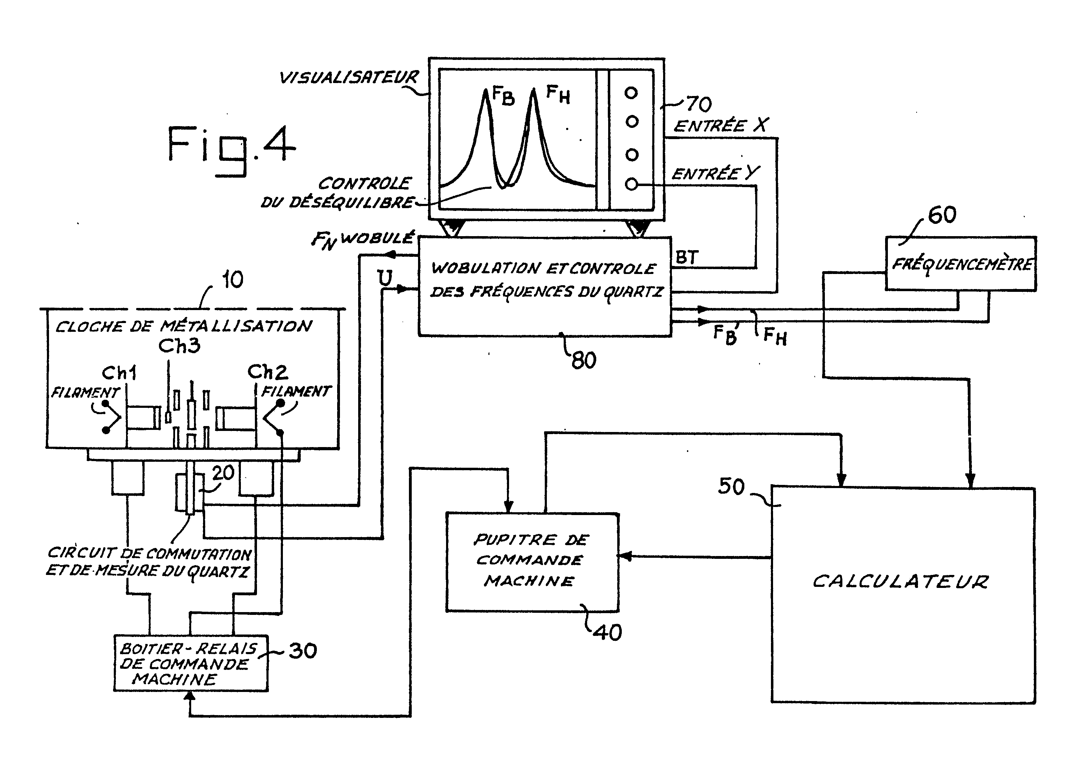

On décrira maintenant, avec référence aux figures 4 à 10, un banc permettant la mise en oeuvre du procédé de la présente invention.

Comme représenté sur la figure 4, le banc de mesure comporte essentiellement une cloche de métallisation 10, un circuit de commutation et de mesure du quartz 20, un boîtier relais de commande machine 30, un pupitre de commande machine 40, un calculateur 50, un fréquencemètre 60, un visualisateur 70 et un circuit de wobulation et de contrôle des fréquences du quartz 80.

De manière plus spécifique, la cloche de métallisation 10 comporte un bâti 11 sur lequel est placée la lame de quartz 12 à métalliser. Cette lame de quartz est entourée par trois caches mobiles CH1, CH3, CH2 qui peuvent être déplacés pour cacher l'une ou l'autre partie du quartz en fonction d'un ordre de commande issu du boîtier relais 30 ou par déplacement manuel comme cela sera expliqué de manière plus détaillée ci-après. D'autre part, la cloche de métallisation comporte des filaments de chauffage permettant de réaliser la métallisation par évaporation sous vide. Ces filaments de chauffage sont aussi reliés au boîtier 30 de manière à être commandés manuellement ou automatiquement comme cela sera expliqué ci-après.

Le boîtier relais de commande machine est relié au pupitre de commande machine 40. Le rôle du pupitre de commande machine est d'initialiser un certain nombre d'opérations, notamment l'opération de métallisation de base, et de servir d'interface entre le calculateur et le boîtier relais de commande machine 30 lorsque les opérations automatiques ont été mises en route.

Le calculateur 50 est utilisé principalement pour réaliser le calcul de la bande passante à partir des fréquences haute et basse issues du fréquencemètre et pour comparer la bande passante ainsi que les différentes fréquences issues du fréquencemètre à des valeurs de référence qui ont été initialisées à l'intérieur du calculateur.

Le fréquencemètre 60 est utilisé principalement comme moyen pour numériser les fréquences haute et basse détectées par le circuit 80. Il permet en outre d'assurer un affichage de ces fréquences. Toutefois, il est évident pour l'homme de l'art qu'un autre moyen de numérisation peut être utilisé à la place du fréquencemètre 60.

Le visualisateur 70 permet de visualiser simultanément, par superposition, les deux courbes de transmission en fréquence obtenues lorsque l'une ou l'autre des électrodes séparées est mise en court-circuit. En utilisant le visualisateur, on peut contrôler l'équilibrage du quartz. L'équilibre est atteint lorsque les zéros de transmission des deux courbes apparaissant sur le visualisateur sont en concordance.

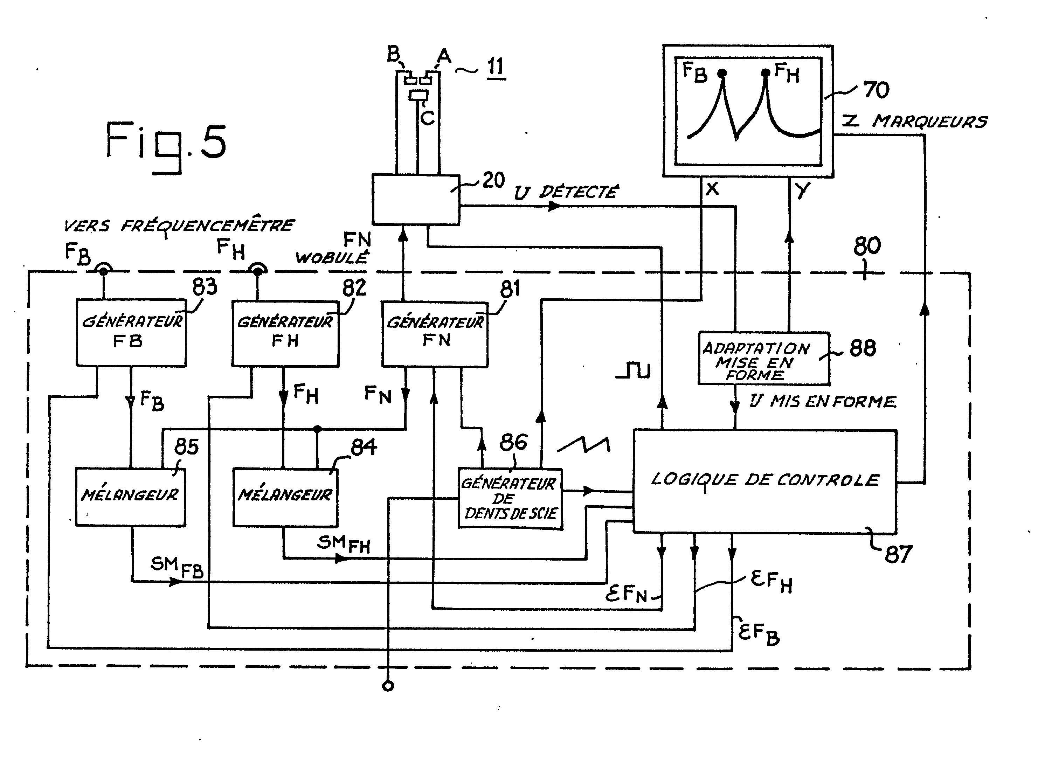

Le circuit 80 de wobulation et de contrôle de la fréquence du quartz sera décrit de manière détaillée en se référant aux figures 5 à 8. Comme représenté sur la figure 5, le circuit 80 comporte essentiellement un générateur de fréquence nominale 81, un générateur de fréquence haute 82 et un générateur de fréquence basse 83. Le générateur de fréquence nominale 81 envoie une fréquence nominale wobulée à l'entrée du circuit de mesure du quartz. Le circuit de mesure utilisé dans ce cas est un circuit classique bien connu de l'homme de l'art et ne sera pas décrit en détail ici. Toutefois, à ce circuit de mesure est associé un circuit de commutation pour mettre en court-circuit avec l'électrode commune, l'une ou l'autre des deux électrodes séparées. Comme cela sera expliqué ci-après, la fréquence nominale wobulée correspond à la fréquence nominale du quartz à un instant donné wobulée sur quelques dizaines de kilohertz de manière à obtenir en sortie du circuit de mesure une tension variant en fonction de la fréquence du quartz, ce qui permet d'avoir la courbe de transmission en fréquence du quartz à un instant donné. La fréquence nominale wobulée issue du générateur 81 est aussi envoyée en entrée d'un mélangeur 84 et d'un mélangeur 85 qui reçoivent l'un une fréquence haute, l'autre une fréquence basse, issues respectivement des générateurs 82 et 83. La fréquence haute et la fréquence basse issues des générateurs 82 et 83 sont aussi envoyées vers le fréquencemètre pour être affichées et numérisées. Pour obtenir la fréquence nominale wobulée, le générateur 81 reçoit une dent de scie issue du générateur de dents de scie 86. Cette dent de scie a été choisie avec une fréquence basse, à savoir 50 Hz dans le mode de réalisation représenté, pour éviter des problèmes au niveau de la visualisation des courbes de transmission en fréquence. En effet, la dent de scie issue du générateur 86 est aussi envoyée sur l'entrée X du visualisateur 70. D'autre part, cette dent de scie est envoyée dans le circuit logique de contrôle 87 qui reçoit aussi le signal SM$_{FH}$ issu du mélangeur 84, le signal SM$_{FB}$ issu du mélangeur 85 ainsi que la tension mise en forme par l'intermédiaire du circuit d'adaptation et de mise en forme 88 issue du circuit de mesure 20.

Le circuit logique de contrôle 87 élabore des signaux de correction de fréquence $\epsilon$FN, $\epsilon$FH, $\epsilon$FB qui sont envoyés respectivement sur les générateurs 81, 82, 83 et dont le rôle sera expliqué ci-après. Il élabore aussi un signal-marqueur qui est envoyé sur l'entrée Z du visualisateur, ce signal-marqueur permet de suivre directement sur les courbes, les fréquences basse et haute. De plus, la tension U détectée issue du circuit de mesure 20 est envoyée après adaptation et mise en forme sur l'entrée Y du visualisateur de manière à obtenir la courbe de transmission en fréquence.

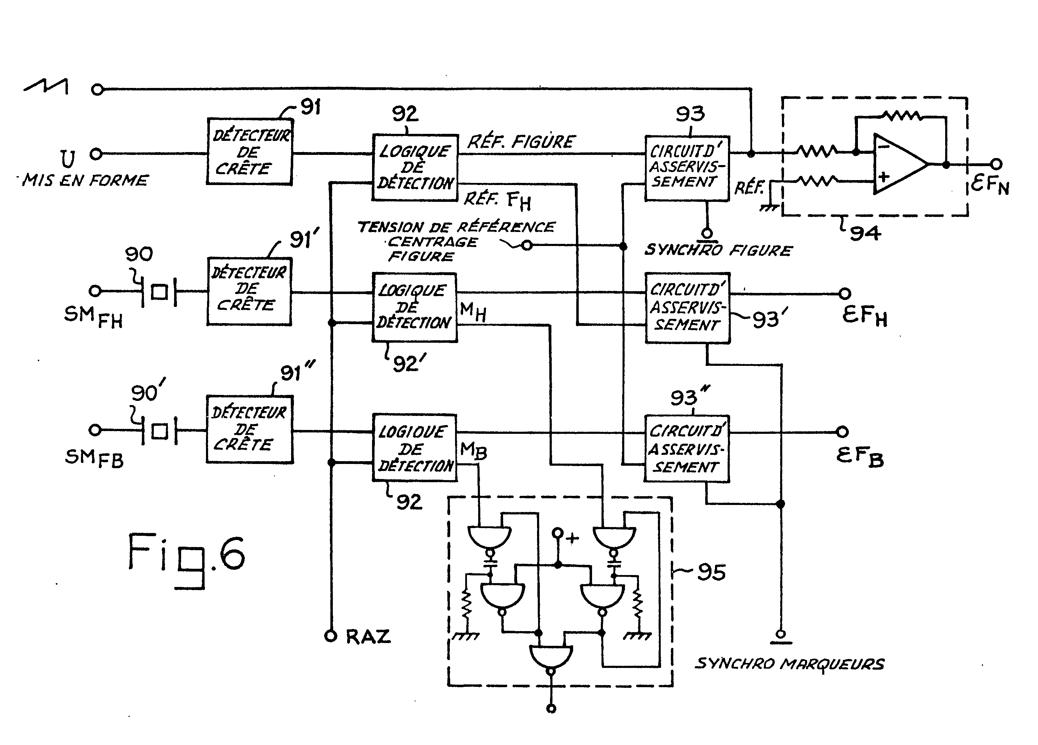

Le circuit logique de contrôle 87 représenté sur la figure 6 comporte essentiellement deux quartz 90 et 90' dont les fréquences de résonance ont été choisies de manière à être légèrement décalées l'une par rapport à l'autre pour éviter des battements. Ainsi, dans le mode de réalisation représenté, la fréquence de résonance du quartz 90 est de 3,5 MHz tandis que la fréquence de résonance du quartz 90' est de 3 MHz. Les deux quartz 90 et 90' reçoivent respectivement les signaux SM$_{FH}$ et SM$_{FB}$ issus des mélangeurs 84 et 85. Ils sont connectés en sortie chacun à un détecteur de crête 91', 91''. La tension U mise en forme issue du circuit 88 est aussi envoyée sur un détecteur de crête 91.

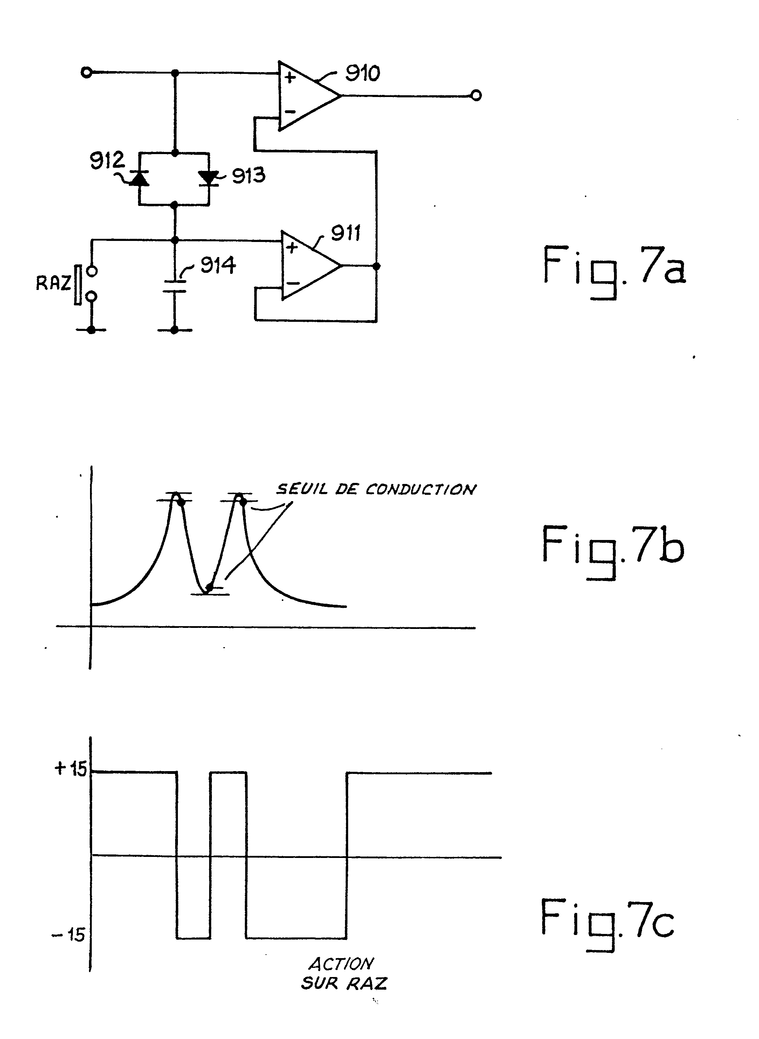

Les trois détecteurs de crête 91, 91', 91'' sont réalisés, par exemple, comme représenté sur la figure 7A. A savoir, ils comportent deux amplificateurs opérationnels 910, 911 connectés ensemble de telle sorte que les signaux d'entrée E sont appliqués sur l'entrée directe de l'amplificateur 910 alors que l'entrée directe de l'amplificateur 911 reçoit un signal de remise à zéro. Les entrées indirectes des deux amplificateurs 910 et 911 sont reliées entre elles et reliées à la sortie de l'amplificateur 911 ; le signal de sorties du détecteur de crête est obtenu sur l'amplificateur 910. D'autre part, entre les deux entrées directes des amplificateurs 910 et 911 sont connectées deux diodes 912 et 913 en parallèle, les diodes étant montées de manière à être passantes, l'une dans un sens, l'autre dans l'autre. Entre l'entrée de l'amplificateur 911 et la masse, est monté un condensateur 914. On expliquera le fonctionnement de ce détecteur de crête à l'aide des figures 7B et 7C. Ainsi, après remise à zéro, la tension d'entrée E charge le condensateur 914 à travers la diode 913 dont le sens est passant. La tension en sortie de l'amplificateur 911 monté en suiveur est toujours inférieure à la tension E. En conséquence, la sortie S est sans changement. Après passage au niveau du premier sommet de la courbe de transmission en fréquence du quartz représentée su la figure 7B, la diode 913 se bloque et le condensateur 914 étant chargé maintient à la sortie de l'amplificateur suiveur 911 une tension supérieure à la tension E, ce qui provoque un brusque changement de polarité du niveau de la sortie S. Lorsque la tension E passe en-dessous du seuil de conduction de l'autre diode 912, la capacité 914 est déchargée et ceci jusqu'à la nouvelle crête de la courbe de la figure 7B. On obtient donc la tension de sortie représentée sur la figure 7C. Pour obtenir un système répétitif, on peut décharger la capacité 914 en utilisant un signal de remise à zéro RAZ de manière à se retrouver dans la même position de départ lors de chaque cycle.

Les signaux issus des détecteurs de crête 91, 91', 91″ sont envoyés sur des logiques de détection 92, 92', 92″ qui sont constituées par des circuits JK dans le mode de réalisation représenté et donnent à partir d'un signal du type de celui représenté à la figure 7C des signaux rectangulaires constituant le signal de référence figure, le signal de référence fréquence haute, le signal de référence fréquence basse, le signal marqueur haut et le signal marqueur bas. Ces logiques de détection reçoivent en entrée un signal RAZ permettant le fonctionnement cyclique du système.

Les signaux MH et MB issus des logiques de détection 92' et 92″ sont envoyés vers un circuit 95 constitué de ET inversé qui permet, à partir des deux signaux MH et MB, d'obtenir un seul signal envoyé sur l'entrée Z du visualisateur. D'autre part, des signaux MH et MB correspondants sont envoyés vers le circuit d'asservissement 93', 93″. Un circuit d'asservissement identique 93 reçoit le signal référence figure issu du circuit 92. Une tension de référence centrage figure est aussi appliquée sur les circuits d'asservissement 93, 93″ tandis que le circuit d'asservissement 93' reçoit une tension de référence fréquence haute FH. Le circuit d'asservissement 93 est commandé par l'action sur une touche synchro-figure tandis que les circuits d'asservissement 93', 93″ sont commandés par l'action sur une touche synchro-marqueur.

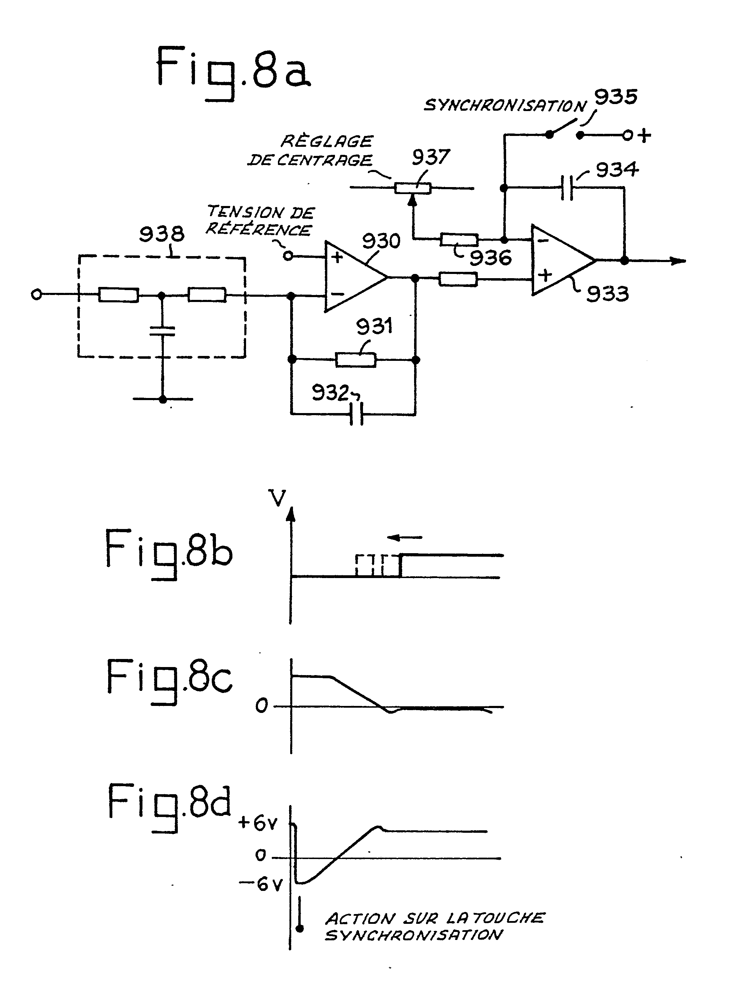

La constitution des circuits d'asservissement 93, 93', 93″ ainsi que leur fonctionnement seront mieux compris en se référant aux figures 8A à 8D qui donnent une représentation schématique de ces circuits. Chaque circuit d'asservissement comporte essentiellement un comparateur constitué de manière connue d'un amplificateur opérationnel 930 comprenant une boucle de réaction formée d'une résistance 931 et d'une capacité 932 montées en parallèle entre la sortie de l'amplificateur opérationnel 930 et l'entrée négative dudit amplificateur. Le signal issue du circuit logique de détection, à savoir le signal référence figure ou les signaux marqueur haut et marqueur bas, est envoyé sur l'entrée négative de l'amplificateur 930 à travers un circuit de filtrage 938. Cet amplificateur 930 reçoit sur son entrée positive une tension de référence qui, suivant le cas, est constituée soit par une tension de référence centrage figure pour les circuits 93 et 93″, soit par le signal de référence fréquence haute issu du circuit logique 92 pour le circuit 93'. On obtient en sortie du comparateur un signal d'erreur qui est appliqué par l'intermédiaire d'une résistance 936 sur l'entrée positive d'un amplificateur opérationnel 933. Cet amplificateur opérationnel 933 est monté en générateur de rampe. Il comporte entre sa sortie et son entrée négative une boucle de contre réaction avec une capacité 934. Cette capacité 934 est connectée à une touche de synchronisation 935 qui, lorsqu'elle est fermée, envoie une tension positive et charge la capacité 934. D'autre part, l'entrée négative de l'amplificateur 933 est reliée par l'intermédiaire d'une résistance 936 à un potentiomètre 937 qui permet un réglage de centrage comme cela sera expliqué ci-après.

Les figures 8B à 8D représentent la tension en différents points A, B et C du circuit d'asservissement. Ainsi, initialement, la tension au point B représentée sur la figure 8C est égale à la tension de référence. Puis, lorsque l'on appuie sur la touche de synchronisation 935, on met en route le circuit comme cela sera expliqué de manière plus détaillée ci-après. En conséquence, on charge le condensateur 934, ce qui donne l'impulsion représentée sur la figure 8D. On relâche la touche de synchronisation et le condensateur 934 se décharge lentement en créant une rampe au niveau du point C. D'autre part, le point A reçoit un signal rectangulaire représenté sur la figure 8B issu de la logique de détection. Ce signal rectangulaire est intégré par le circuit 938 et comparé à la tension de référence pour donner au point B un signal d'erreur. Ce signal d'erreur qui, à partir de la mise en oeuvre du système, décroît lentement comme représenté sur la figure 8C, est donc comparé à la rampe lente et bloque son évolution lorsque les fréquences des différents générateurs correspondent aux différentes fréquences du quartz puisque le signal issu du point C est envoyé comme signal d'erreur sur ces générateurs. On obtient ainsi un verrouillage du système et un suivi en continu des différentes fréquences. Ces fonctions apparaîtront de manière plus évidente lors de la description complète du fonctionnement du circuit de wobulation et de contrôle du quartz.

Ainsi, comme représenté sur la figure 5, les signaux $\epsilon FH$, $\epsilon FB$ issus des circuits d'asservissement 93' et 93″ sont envoyés comme signaux d'erreur sur les générateurs fréquence basse 83 et fréquence haute 82. D'autre part, le signal issu du circuit d'asservissement 93 est ajouté au signal en dents de scie issue du générateur de dents de scie 86 comme représenté sur la figure 6, ce signal est appliqué sur un circuit 94 constitué d'un amplificateur opérationnel monté en inverseur. On obtient en sortie de ce circuit 94 un signal d'erreur $\epsilon$FN plus le signal de dent de scie appliqué sur le générateur de fréquence nominale 81.

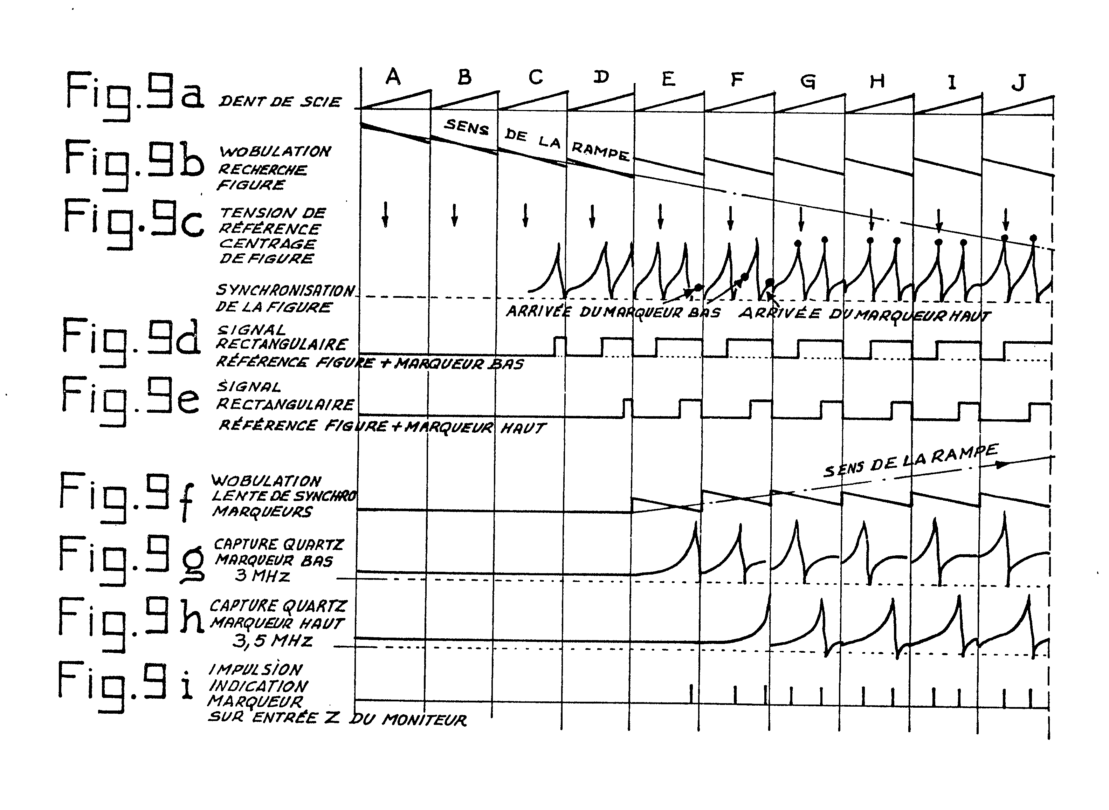

On décrira maintenant, de manière plus détaillée, avec référence aux figures 9A à 9I le fonctionnement du circuit de wobulation 80 représenté sur les figures 5 à 8. Après avoir réalisé par commande manuelle du système une métallisation de base, on met en route le fonctionnement automatique du système. Pour permettre ce fonctionnement automatique, le générateur de fréquence nominale 81 a été positionné à une valeur de fréquence égale à la fréquence nominale ou fréquence d'arrêt moins $\Delta$F. Dans le présent cas, $\Delta$F peut être choisi égal à 200 KHz pour une fréquence d'arrêt de 21,4 MHz. Par ailleurs, le générateur de fréquence basse 83 se trouve positionné à une valeur égale à la fréquence d'arrêt ou fréquence nominale moins la fréquence du quartz placé dans le circuit 87 et choisie égale à 3 MHz dans le présent cas plus $\Delta$F1 et le générateur de fréquence haute 83 se trouve positionné à une valeur égale à la fréquence d'arrêt moins la fréquence du quartz monté dans le circuit 87 et choisie égale à 3,5 MHz plus $\Delta$F1. En effet, pour obtenir une métallisation correcte du quartz et ne pas dépasser la fréquence d'arrêt et la bande passante choisie, il est nécessaire d'avoir un sens de wobulation croissant pour le générateur de fréquence nominale 81 et d'avoir un sens de wobulation décroissant pour le générateur de fréquence basse et le générateur de fréquence haute.

L'initialisation du système est réalisée en appuyant sur la touche synchro-figure. Ceci crée, comme mentionné ci-dessus, une rampe lente qui est appliquée sur le générateur de fréquence nominale 81 et qui fait évoluer la fréquence de ce générateur dans le sens croissant vers une valeur choisie égale à la fréquence nominale plus $\Delta$F2. Comme représenté sur la figure 9B, à cette rampe est superposée une dent de scie de fréquence 50 Hz dans le mode de réalisation choisi, issue du générateur 86. Sur la figure 9, le sens de la rampe est décroissant car les diodes varicaps positionnées en entrée du générateur 81 sont reliées à une tension négative, ce qui correspond à une inversion du sens de la rampe.

Lorsque la fréquence du générateur 81 atteint la valeur de la fréquence nominale du quartz placé sur le circuit de mesure dans le circuit 20, la courbe de transmission en fréquence telle que représentée sur la figure 9C apparaît sur l'écran du visualisateur 70 (voir partie C de la figure 9C). A ce moment, le circuit détecteur de crête entre en action. Un signal rectangulaire est issu de cette détection comme expliqué ci-dessus avec référence aux figures 7. Ce signal est proportionnel à la position de la figure sur l'écran comme représenté figure 9D, partie C. Ce signal est intégré, puis comparé à une valeur de référence ajustable appelée, dans ce cas, centrage figure comme expliqué avec référence aux figures 6 et 8. Le signal d'erreur obtenu en sortie du comparateur est appliqué sur l'amplificateur opérationnel générateur de la rampe lente et stoppe brutalement son évolution lorsque la tension de centrage figure est obtenue, c'est-à-dire lorsque le signal d'erreur est nul comme représenté sur les figures 9C, 9D et 9E, partie E et suivantes. A ce moment, le système est verrouillé, c'est-à-dire que toute modification de la fréquence du quartz ne modifiera pas la position de la figure, mais que cette modification de fréquence du quartz sera suivie au niveau du générateur 81.

On a expliqué ci-dessus le fonctionnement de la capture de la courbe de transmission en fréquence du quartz monté sur le circuit de mesure dans le circuit 20, on expliquera maintenant le fonctionnement de la capture des fréquences haute et basse de ce quartz permettant la commande automatique de la métallisation ainsi que la création de marqueurs venant se superposer sur les courbes de transmission en fréquence.

La capture des fréquences haute et basse se fait de façon simultanée pour les deux fréquences et d'une manière sensiblement identique à la capture de la figure. Ainsi, lorsque l'on appuie sur la touche synchro-marqueur, la fréquence du générateur de fréquence basse 83 se trouve à une valeur égale, dans le mode de réalisation représenté, à la fréquence d'arrêt - 3 MHz + 800 KHz et la fréquence du générateur de fréquence haute 82 se trouve à une valeur égale à la fréquence d'arrêt - 3,5 MHz + 800 KHz. Ces fréquences ont été choisies pour des fréquences basses pouvant évoluer entre 18,8 MHz et 18 MHz et pour des fréquences hautes pouvant évoluer entre 18,3 MHz et 17,5 MHz. Toutefois, il est évident pour l'homme de l'art que ces fréquences ont été données uniquement à titre d'exemple. Les fréquences des générateurs 83 et 82 sont mélangées avec la fréquence du générateur de fréquence nominale 81. On obtient alors en sortie du mélangeur 85 un signal SM$_{FB}$ ayant une fréquence de 3 MHz + ou - la wobulation et un signal SM$_{FH}$ ayant une fréquence de 3,5 MHz + ou - la wobulation.

L'évolution en fréquence se faisant dans ce cas toujours d'une façon croissante, chaque signal est appliqué sur un quartz de 3 MHz pour la fréquence basse et de 3,5 MHz pour la fréquence haute de manière à éviter les battements entre les deux fréquences. Les signaux issus des quartz tels que représentés sur les figures 9G et 9H sont envoyés sur un circuit de détection de crête fonctionnant comme mentionné ci-dessus. On obtient en sortie du circuit de détection de crête un signal rectangulaire proportionnel à la position de la fréquence basse pour le signal issu du quartz 3 MHz et à celle de la fréquence haute pour le signal issu du quartz 3,5 MHz. Après intégration de ces signaux, ils sont chacun envoyés sur un comparateur et comparés, soit avec le signal de référence de fréquence haute correspondant à la fréquence haute du quartz monté sur le circuit de mesure 20 et issu du circuit de détection logique 92, soit avec la tension de référence centrage figure utilisée pour la capture de la figure dans le cas de la fréquence basse. Des signaux d'erreur issus des deux comparateurs sont appliqués aux amplificateurs opérationnels générateurs de rampe et stoppent brutalement l'évolution de la rampe en verrouillant ainsi le système respectivement sur la fréquence basse et la fréquence haute du quartz. Les fréquences basse et haute ainsi obtenues sont envoyées vers un calculateur par l'intermédiaire d'un fréquencemètre de manière à obtenir des signaux de commande de métallisation. D'autre part, les signaux issus des logiques de détection 92, 92' sont envoyés dans le circuit 95 pour donner les impulsions représentées sur la figure 9I qui sont appliquées sur la voie Z du visualisateur 70 de manière à visualiser le marqueur haut et le marqueur bas par rapport à la courbe de transmission en fréquence du quartz. La position des marqueurs qui doivent être verrouillés sur les pointes FB et FH peut être modifiée légèrement en jouant sur la tension de centrage.

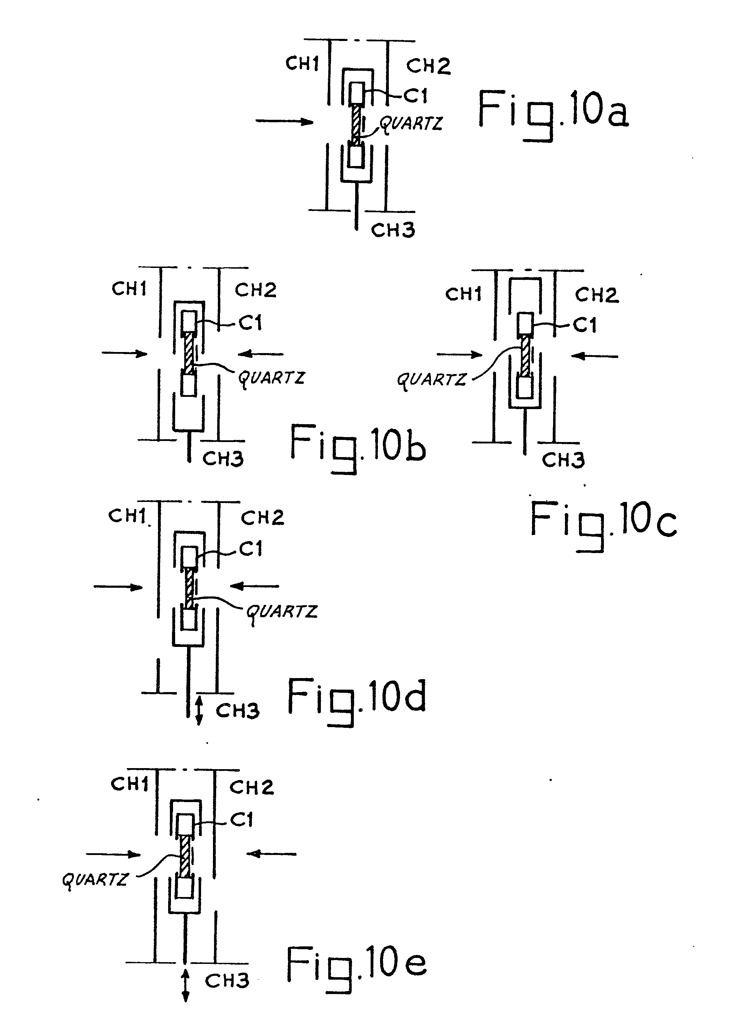

On expliquera maintenant, avec référence aux figures 10A à 10E, la position des caches lors des différentes phases de métallisation en fonction des signaux de commande issus du calculateur. On rappellera tout d'abord que, dans la présente invention, l'équilibrage, c'est-à-dire la superposition des deux courbes de transmission de fréquence obtenues lors de la commutation des électrodes en court-circuit, est réalisé manuellement. Toutefois, il est évident pour l'homme de l'art qu'une commande automatique du cache permettant de réaliser cet équilibrage peut être envisagée. Dans le mode de réalisation représenté, les métallisations sont réalisées à l'aide de trois caches, à savoir le cache CH1 agissant sur l'électrode commune, le cache CH2 agissant sur les électrodes séparées et le cache CH3 agissant sur des demi-électrodes. Au début de la métallisation, les caches sont positionnés comme représenté sur la figure 10A de manière à pouvoir créer une couche de base. Lorsque cette couche de base est créée, on détecte la courbe de transmission en fréquence comme expliqué ci-dessus, et à partir de cette courbe, on réalise une première correction manuelle d'équilibrage par action sur le cache CH3 comme représenté sur les figures 10B et 10C. Ensuite, par action automatique sur le cache CH1 qui est fermé, le cache CH2 étant ouvert et le cache CH3 étant dans une position variable suivant l'équilibre, on réalise l'ajustage de la bande passante. Une fois cet ajustage obtenu par commande automatique issue du calculateur, le cache CH1 est ouvert et, le cache CH2 étant fermé, on réalise une évaporation à pleine puissance de manière à ajuster la fréquence basse à la fréquence choisie, puis lorsque cette fréquence basse est obtenue, on effectue une correction manuelle d'équilibrage par action sur CH3 et l'on recommence automatiquement l'ajustage de la bande passante et l'ajustage de la fréquence basse jusqu'à l'obtention des valeurs désirées. D'autre part, vers la fin des opérations ci-dessus, l'évaporation est réalisée à puissance réduite à partir d'une fréquence de seuil jusqu'à la fréquence d'arrêt afin de ne pas dépasser les valeurs choisies.

Il est évident pour l'homme de l'art que différentes modifications peuvent être apportées, soit au procédé, soit au dispositif, sans sortir du cadre des revendications ci-après.

## Revendications

1. Procédé de mise à la fréquence d'un quartz monolithique couplé comportant sur deux faces en vis-à-vis deux électrodes séparées et une électrode commune ou deux électrodes couplées, caractérisé en ce que l'on réalise, en une seule fois, une métallisation de base, puis la détection de la courbe de transmission en fréquence du quartz monté en court-circuit ; en utilisant cette courbe, on mesure à un instant donné les fréquences haute et basse du quartz et on vérifie l'équilibrage ; les fréquences haute et basse sont comparées aux fréquences à obtenir et le résultat de la comparaison est envoyé comme commande de caches de métallisation, les caches agissant sur les deux faces du quartz, à savoir la face des électrodes séparées pour la mise à la fréquence de la largeur de bande passante et l'autre face pour la mise à la fréquence nominale du quartz et les opérations de mesure et de comparaison des fréquences étant recommencées jusqu'à l'obtention des valeurs désirées avec, à chaque fois, vérification de l'équilibrage.

2. Procédé selon la revendication 1, caractérisé par le fait de :

a) réaliser une métallisation de base,

b) pendant toute la durée des opérations suivantes, détecter cycliquement pour chaque électrode séparée la courbe de transmission en fréquence du quartz monté en court-circuit,

c) réaliser l'équilibrage du quartz en métallisant l'une ou l'autre des deux électrodes séparées pour amener en concordance les zones de transmission de deux courbes successives correspondant aux électrodes en court-circuit,

d) à l'aide des courbes ci-dessus, déterminer les fréquences haute et basse du quartz à un instant donné,

e) calculer la bande passante,

f) comparer la bande passante à une bande passante de référence,

g) métalliser les deux électrodes séparées pour amener la bande passante calculée à la valeur de la bande passante de référence,

h) simultanément, comparer la fréquence basse à une fréquence nominale de référence,

i) métalliser l'électrode commune ou les deux électrodes couplées pour amener la fréquence basse détectée à la valeur de la fréquence nominale de référence,

j) équilibrer le quartz comme décrit en c),

k) puis, reprendre les opérations en d) jusqu'à ce que les valeurs désirées de la bande passante et de la fréquence basse soient obtenues et que l'équilibrage soit réalisé et, à ce moment, arrêter la métallisation.

3. Procédé selon l'une quelconque des revendications 1 et 2, caractérisé en ce que l'on compare la fréquence basse à une fréquence de seuil et lorsque cette fréquence de seuil est atteinte, l'on réduit la vitesse de métallisation.

4. Procédé selon la revendication 3, caractérisé en ce que l'on utilise plusieurs fréquences de seuil.

5. Procédé selon l'une quelconque des revendications 1 à 4, caractérisé en ce que les métallisations des deux électrodes séparées, de l'électrode commune ou des électrodes couplées et de l'une ou l'autre des deux électrodes séparées sont réalisées en agissant sur trois caches mobiles.

6. Procédé selon la revendication 5, caractérisé en ce que les caches pour la métallisation de l'électrode commune et pour la métallisation des deux électrodes séparées sont commandés automatiquement en fonction du résultat des différentes comparaisons.

7. Procédé selon la revendication 5, caractérisé en ce que les courbes de transmission en fréquence du quartz sont visualisées et en ce que le cache pour réaliser la métallisation des électrodes séparées est commandé manuellement.

8. Un banc pour la mise en oeuvre du procédé selon l'une quelconque des revendications 1 à 7, caractérisé en ce qu'il comporte une cloche de métallisation (10) munie des moyens de métallisation et de caches mobiles (CH1, CH2, CH3), un dispositif (20) pour mesurer à chaque instant la courbe de transmission en fréquence du quartz monté en court-circuit et pour commuter cycliquement l'électrode séparée montée en court-circuit, des moyens (70) pour réaliser, à partir des courbes de transmission, l'équilibrage du quartz, des moyens (80) pour réaliser, à chaque instant, à partir des courbes de transmission, la détection et le suivi des fréquences haute, basse et nominale du quartz, des moyens (60, 50) permettant d'utiliser les différentes fréquences pour commander les moyens de métallisation et, au moins, certains des caches mobiles.

9. Un banc selon la revendication 8, caractérisé en ce que les moyens pour réaliser, à partir des courbes de transmission, l'équilibrage du quartz sont constitués par un visualisateur (70) superposant les deux courbes de transmission en fréquence obtenues en court-circuitant l'une ou l'autre des électrodes séparées et par un cache mobile (CH3) agissant sur les demi-électrodes et commandé manuellement pour amener les deux courbes visualisées en concordance.

10. Un banc selon la revendication 8, caractérisé en ce que les moyens pour réaliser, à partir des courbes de transmission, la détection et le suivi des fréquences haute, basse et nominale sont constitués par un circuit de wobulation et de contrôle de la fréquence du quartz comprenant un générateur de fréquence nominale (81) wobulé en fréquence, des moyens (91, 93, 94) pour asservir la fréquence du générateur de fréquence nominale à la fréquence nominale du quartz à un instant donné, un générateur de fréquence haute (82), des moyens (84, 90, 91', 93') pour asservir la fréquence du générateur de fréquence haute à la fréquence haute du quartz à un instant donné, un générateur de fréquence basse (83) et des moyens (85, 90', 91", 93") pour asservir la fréquence du générateur de la fréquence basse à la fréquence haute du quartz à un instant donné ; les générateurs de fréquences haute et basse délivrant lesdites fréquences vers un moyen de numérisation (60) et le générateur de fréquence nominale délivrant une fréquence wobulée vers le circuit de mesure (20) donnant la courbe de transmission en fréquence du quartz.

11. Un banc selon la revendication 10, caractérisé en ce que la fréquence basse et la fréquence nominale sont égales.

12. Un banc selon la revendication 8, caractérisé en ce que les moyens permettant d'utiliser les différentes fréquences pour commander les moyens de métallisation sont constitués d'un moyen de numérisation (60) et d'un calculateur (50).

13. Un banc selon l'lune quelconque des revendications 10 et 12, caractérisé en ce que le moyen de numérisation est constitué par un fréquencemètre.

MISE EN PLACE DU QUARTZ
À AJUSTER

NETTOYAGE ALCOOL EAU
SÉCHAGE

MESURE : ÉQUILIBRAGE
"  FRÉQUENCE HAUTE
"  FRÉQUENCE BASSE

$F_2 < F_1 < F_2 \atop \overline{\overline{F_2}}$

TEST OU CONTROLE
D'ÉQUILIBRAGE

MOUILLAGE À L'EAU

PASSAGE B
AU BAIN AU +

MISE EN ROUTE
DU BAIN

MOUILLAGE À L'EAU

PASSAGE A
AU BAIN AU +

MISE EN ROUTE
DU BAIN

CONTROLE
DE LA
FRÉQUENCE
BASSE

$F_b \geqslant F_N > + b$

$\Delta F_x > \Delta F_N > \Delta F_x \atop \overline{\overline{\Delta F_x}}$

MOUILLAGE À L'EAU

PASSAGE AU
CYANURE DE C

MOUILLAGE À L'EAU

PASSAGE A ET B
AU BAIN AU +

MISE EN ROUTE
DU BAIN

MOUILLAGE À L'EAU

PASSAGE A, B, C
AU BAIN AU +

MISE EN ROUTE
DU BAIN

QUARTZ
TERMINE

Fig.1

0 240 645

Fig.2a

Fig.2b

PÔLES

ZÉROS

$F_B$   $F_H$

Fig.3

$F_B$   $F_H$          $F_B$   $F_H$

DÉTECTION DU
QUARTZ WOBULÉ

A B          A B

C            C

1            2

COMMUTATION
DE FIGURE

Fig.4

VISUALISATEUR

$F_B$ $F_H$

70
ENTRÉE X

ENTRÉE Y

CONTROLE
DU DÉSÉQUILIBRE

$F_N$ WOBULÉ

WOBULATION ET CONTROLE
DES FRÉQUENCES DU QUARTZ

BT

60

FRÉQUENCEMÈTRE

U

80

$F_B$ $F_H$

10

CLOCHE DE MÉTALLISATION

Ch3

Ch1

FILAMENT

Ch2

FILAMENT

20

CIRCUIT DE COMMUTATION
ET DE MESURE DU QUARTZ

50

PUPITRE DE
COMMANDE
MACHINE

CALCULATEUR

40

BOITIER-RELAIS
DE COMMANDE
MACHINE

30

0 240 645

Fig.5

VERS FRÉQUENCEMÈTRE

$F_B$  $F_H$  FN WOBULÉ

U DÉTECTÉ

Z MARQUEURS

83 GÉNÉRATEUR F B

82 GÉNÉRATEUR F H

81 GÉNÉRATEUR F N

$F_B$  $F_H$  $F_N$

85 MÉLANGEUR

84 MÉLANGEUR

86 GÉNÉRATEUR DE DENTS DE SCIE

88 ADAPTATION MISE EN FORME

U MIS EN FORME

87 LOGIQUE DE CONTROLE

$SM_{FH}$

$SM_{FB}$

$\mathcal{E}F_N$  $\mathcal{E}F_H$

$\mathcal{E}F_B$

0 240 645

Fig.6

0 240 645

Fig. 7a

SEUIL DE CONDUCTION

Fig. 7b

+ 15

− 15

ACTION
SUR RAZ

Fig. 7c

# Fig.8a

SYNCHRONISATION 935

RÉGLAGE DE CENTRAGE 937

934

TENSION DE RÉFÉRENCE 930

936

938 933

931

932

# Fig.8b

V

# Fig.8c

0

# Fig.8d

+6v
0
−6v

ACTION SUR LA TOUCHE SYNCHRONISATION

Fig.9a DENT DE SCIE

Fig.9b WOBULATION RECHERCHE FIGURE

Fig.9c TENSION DE RÉFÉRENCE CENTRAGE DE FIGURE

SYNCHRONISATION DE LA FIGURE

Fig.9d SIGNAL RECTANGULAIRE RÉFÉRENCE FIGURE + MARQUEUR BAS

Fig.9e SIGNAL RECTANGULAIRE RÉFÉRENCE FIGURE + MARQUEUR HAUT

Fig.9f WOBULATION LENTE DE SYNCHRO MARQUEURS

Fig.9g CAPTURE QUARTZ MARQUEUR BAS 3 MHz

Fig.9h CAPTURE QUARTZ MARQUEUR HAUT 3,5 MHz

Fig.9i IMPULSION INDICATION MARQUEUR SUR ENTRÉE Z DU MONITEUR

SENS DE LA RAMPE

ARRIVÉE DU MARQUEUR BAS     ARRIVÉE DU MARQUEUR HAUT

SENS DE LA RAMPE

0 240 645

Fig.10a

Fig.10b

Fig.10c

Fig.10d

Fig.10e

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | US-A-4 343 827  (E.C. THOMPSON)<br>* En entier * | 1,2 | H 03 H   3/04 |
| A | --- | 6,7,9 | |
| Y | WESTERN ELECTRIC - TECHNICAL DIGEST, no. 42, avril 1976, pages 23-24, Western Electric, New York, US; J.D. JENNINGS: "Fine tuning monolithic crystal filters"<br>* En entier *<br>--- | 1,2 | |
| A | US-A-4 131 484  (R.D. CARUSO)<br>* Colonne 2, lignes 17-38 *<br>--- | 3 | |
| A | DE-A-2 245 934  (SIEMENS)<br>* En entier *<br>----- | 1,3 | **DOMAINES TECHNIQUES RECHERCHES (Int. Cl.4)**<br><br>H 03 H |

Le présent rapport de recherche a été établi pour toutes les revendications

| Lieu de la recherche | Date d'achèvement de la recherche | Examinateur |
|---|---|---|
| LA HAYE | 01-04-1987 | COPPIETERS C. |